# EUROPEAN PATENT APPLICATION

(11) **EP 4 227 147 A2**
(43) Date of publication of application: **16.08.2023**
(21) Application number: 23152001.6
(22) Date of filing: 17.01.2023
(51) Int. Cl.: B60L 50/00, H05K 9/00

(54) **INTERNAL EMC PROTECTION FOR SHIELD FOR PLASTIC HIGH VOLTAGE DISTRIBUTION CENTERS**

(30) Priority: 21.01.2022 US 202263301822 P; 19.05.2022 US 202263343646 P; 16.01.2023 US 202318097400
(71) Applicant: Aptiv Technologies Limited, St. Michael (BB)
(72) Inventor: FERRUCIO, Marcio, 12235-560 Sao Jose dos Campos (BR); SILVA, Fernando Jose, 12301-140 Jacarei (BR); BOYER, Richard J., Mantua, 44255 (US); SPADONI, Steve, Plymouth, 48170 (US); BIZON, Don E., Boardman, 44512 (US); BRANDON, Christopher, El Paso, 79932 (US)
(74) Representative: Westphal, Mussgnug & Partner, Patentanwälte mbB

(57) **Abstract**

An electrical distribution center (100) includes a housing (104) formed of an electrically nonconductive material, an electromagnetic housing shield (110) formed of an electrically conductive material disposed within a cavity (112) in the housing (104), a cover (116) enclosing the cavity (112) having an electromagnetic cover shield (118) formed of the electrically conductive material and in electrical contact with the housing shield (110), and a plurality of shielded electrical connectors (102) interconnected to one another through electrical components (126) contained within the cavity (112). The electrical components (126) are mounted on a plurality of standoffs (128) defined by an inner surface of the housing (104). The plurality of standoffs (128) extends through a plurality of apertures (130) defined in the housing shield (110).

## Description

This disclosure is directed to high voltage electrical distribution centers and more particularly high voltage electrical distribution centers for electrical vehicles having a polymeric case and internal electromagnetic compatibility (EMC) protection.

Electromagnetic shielding for electrical distribution centers has typically been provided by housings that are made of an electrically conductive metallic material, such as aluminum. However, an alternative to aluminum housings is desired in order to reduce the weight and cost of the housings, to avoid potential corrosion issues seen with aluminum housings, and to eliminate the risk of short circuiting high power electrical bus bars by contact with the electrically conductive aluminum housing during a crash or other similar event.

According to an embodiment, an electrical distribution center is provided. The electrical distribution center includes a housing formed of an electrically nonconductive material, an electromagnetic housing shield formed of an electrically conductive material disposed within a cavity in the housing, a cover enclosing the cavity having an electromagnetic cover shield formed of the electrically conductive material and in electrical contact with the housing shield, and a plurality of shielded electrical connectors interconnected to one another through electrical components contained within the cavity. Electrical components are mounted on a plurality of standoffs defined by an inner surface of the housing. The plurality of standoffs extends through a plurality of apertures defined in the housing shield.

In one or more embodiments of the electrical distribution center according to the previous paragraph, the cover shield is mounted to the cover by a plurality of fasteners and the plurality of fasteners extend through a plurality of apertures defined in the cover shield.

In one or more embodiments of the electrical distribution center according to any one of the previous paragraphs, connector shields of the plurality of shielded electrical connectors are in electrical contact with the housing shield.

In one or more embodiments of the electrical distribution center according to any one of the previous paragraphs, at least one of the connector shields is disposed within a connector shroud integrally formed by the housing.

In one or more embodiments of the electrical distribution center according to any one of the previous paragraphs, at least one of the electrical components is a fuse.

In one or more embodiments of the electrical distribution center according to any one of the previous paragraphs, the housing shield and the cover shield are formed of brass alloy containing about 70% copper and about 30% tin.

In one or more embodiments of the electrical distribution center according to any one of the previous paragraphs, the housing shield and the cover shield have a thickness of about 0.3 millimeters.

In one or more embodiments of the electrical distribution center according to any one of the previous paragraphs, the housing shield and the cover shield are formed of a sheet of steel material plated with a tin alloy or a copper alloy.

In one or more embodiments of the electrical distribution center according to any one of the previous paragraphs, the housing shield comprises a plurality of spring tabs configured to make electrical contact with the cover shield.

In one or more embodiments of the electrical distribution center according to any one of the previous paragraphs, the cover is welded to the housing.

According to an embodiment, an electrical distribution center is provided. The electrical distribution center includes a housing formed of an electrically nonconductive material, an electromagnetic shield formed of an electrically conductive material disposed within a cavity in the housing and a plurality of shielded electrical connectors interconnected to one another within the cavity. Connector shields of the plurality of shielded electrical connectors are in electrical contact with the housing shield. A DC resistance between the connector shields is less than or equal to 2.5 milliohms. An AC transfer impedance is less than or equal to 30 milliohms/meter in a frequency range of 10 kilohertz to 1 Megahertz and is less than or equal to 3 × 10⁻⁸ × *f* milliohms/meter in a frequency range 1 Megahertz to 100 Megahertz, where *f* is the frequency of electricity being conducted by the plurality of shielded electrical connectors.

In one or more embodiments of the electrical distribution center according to the previous paragraph, at least one of the connector shields is disposed within a connector shroud integrally formed by the housing.

In one or more embodiments of the electrical distribution center according to any one of the previous paragraphs, there is no electrical discontinuity between the electromagnetic shield and the connector shields.

In one or more embodiments of the electrical distribution center according to any one of the previous paragraphs, the electromagnetic shield and the connector shields cooperate to distribute radio frequency energy evenly throughout the electromagnetic shield and the connector shields.

In one or more embodiments of the electrical distribution center according to any one of the previous paragraphs, the electrical distribution center further includes electrical components contained within the cavity and mounted on a plurality of standoffs defined by an inner surface of the housing. The plurality of standoffs extends through a plurality of apertures defined in the housing shield.

In one or more embodiments of the electrical distribution center according to any one of the previous paragraphs, the electromagnetic shield is mounted on a plurality of standoffs extending from an inside surface of the housing. Tips of the plurality of standoffs extend through a plurality of apertures defined in the electromagnetic shield.

The present invention will now be described, by way of example with reference to the accompanying drawings, in which:
FIG. 1A shows a top view of a high voltage distribution center according to some embodiments;
FIG. 1B shows a left side view of the high voltage distribution center of FIG. 1A according to some embodiments;
FIG. 1C shows a front view of the high voltage distribution center of FIG. 1A according to some embodiments;
FIG. 2 shows a top view of the high voltage distribution center of FIG. 1A with the cover removed according to some embodiments;
FIG. 3 shows a cross section view of a cover assembly secured to a housing assembly of the high voltage distribution center of FIG. 1A using a laser plastic welding process according to some embodiments;
FIG. 4A shows a top view of the cover assembly of the high voltage distribution center of FIG. 1A according to some embodiments;
FIG. 4B shows a bottom view of the cover assembly of FIG. 4A according to some embodiments;
FIG. 4C shows a cross section view of the cover assembly of FIG. 4A along the section line 4C-4C in FIG. 4A according to some embodiments;
FIG. 5 shows a bottom view of the cover assembly of FIG. 4A according to some embodiments;
FIG. 6 separately shows a cover shield of the cover assembly of FIG. 5 according to some embodiments;
FIG. 7 shows a perspective view of a housing of the high voltage distribution center of FIG. 1A according to some embodiments;
FIG. 8 shows a perspective view of a housing shield of the high voltage distribution center of FIG. 1A according to some embodiments;
FIG. 9 shows the shield housing assembly of FIG. 8 installed in the housing of FIG. 7 according to some embodiments;
FIG. 10 shows a high voltage header cavity shield interface to the housing shield of FIG. 8 according to some embodiments;
FIG. 11 shows another high voltage header cavity shield interface to the housing shield of FIG. 8 according to some embodiments;
FIGs. 12A and 12B show isometric and exploded views of the high voltage distribution center of FIG. 1A according to some embodiments;
FIGs. 13A and 13B show isometric and exploded views of the housing and cover shielding according to some embodiments;
FIG. 14 shows a graph of transfer impedance of a high voltage distribution center having a metallic housing according to the prior art and the high voltage distribution center of FIG. 1A;
FIG. 15 shows a flow chart of an assembly process of assembling the high voltage distribution center of FIG. 1A according to some embodiments.

A non-limiting example of a high voltage electrical distribution center that this suitable for use in electric vehicles or hybrid electric vehicles is described as follows. As used herein, the term "high voltage" means having an alternating current (AC) voltage in excess of 60 volts. Of course, embodiments may be envisioned that are suited for lower voltages.

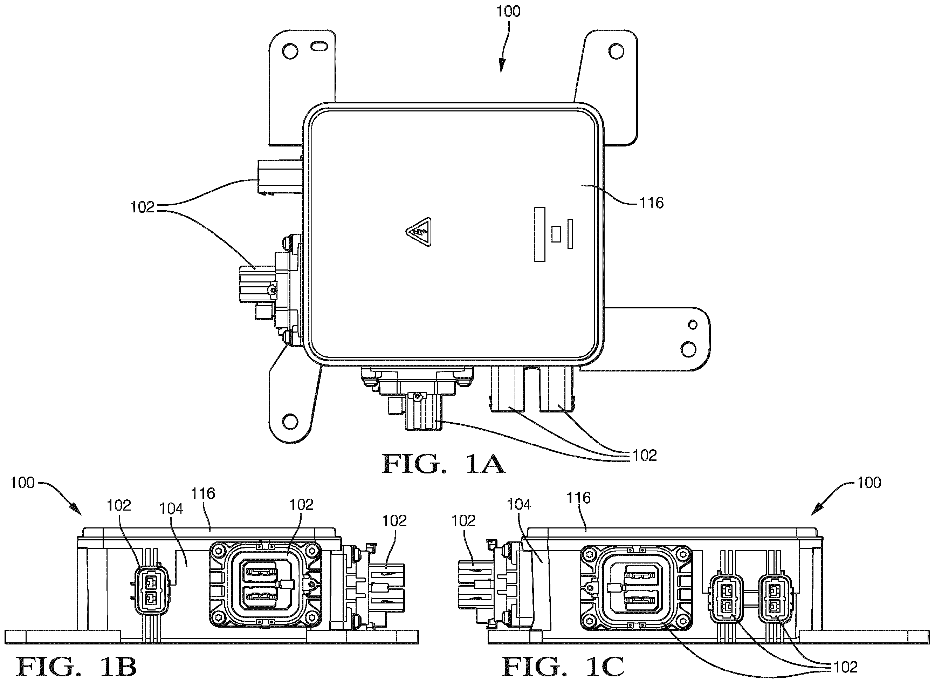

As shown in FIGs. 1A-1C, the electrical distribution center 100 includes a number of shielded electrical connectors 102 that are interconnected within the electrical distribution center 100 in order to provide high voltage AC electrical power from a source, such as a power invertor, to various high voltage circuits within the vehicle. The shielded electrical connectors 102 and electrical distribution center 100 are shielded to provide electromagnetic compliance (EMC) for the AC power conducted through the electrical distribution center.

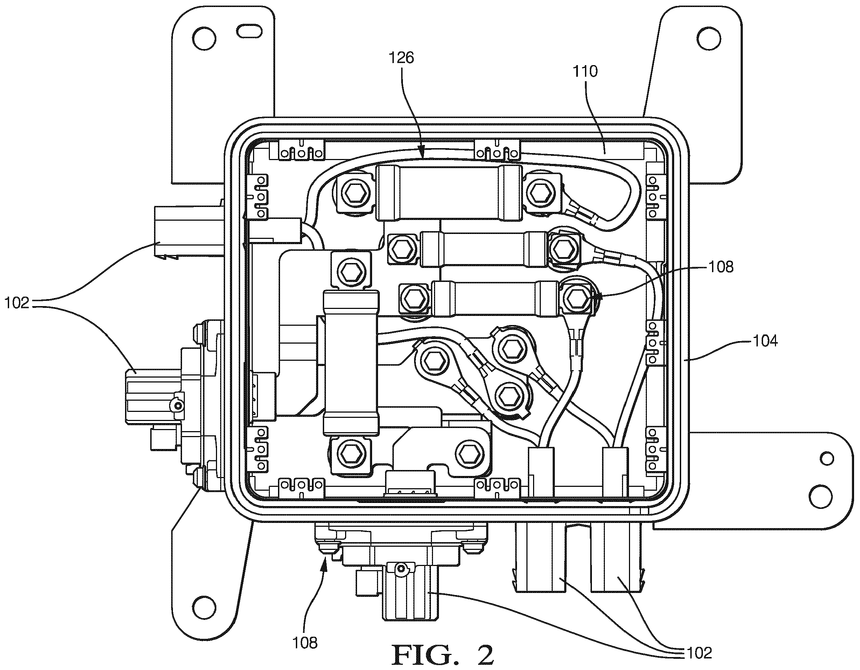

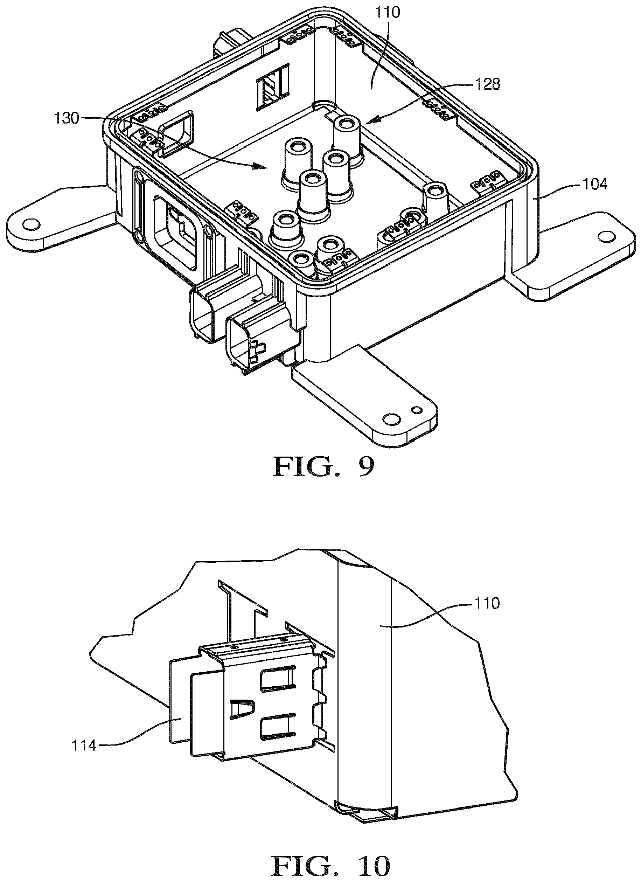

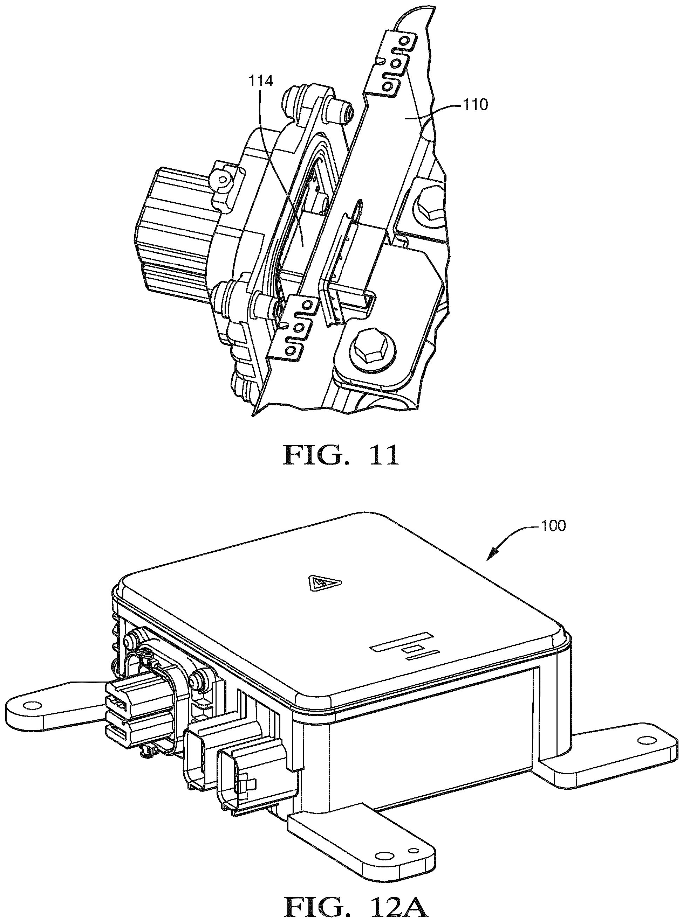

The electrical distribution center 100 includes a housing 104 that is formed of an electrically nonconductive material, such as polyamide (NYLON), polybutylene terephthalate (PBT), or another engineered polymer. The housing 104 also defines a plurality of connector shrouds 106 that are integrally formed with the housing 104. These connector shrouds 106 contain at least some of the shielded electrical connectors 102. Other shielded electrical connectors 102 may be attached to the housing by fasteners 108, such as screws. As shown in FIGs. 2 and 11, an electromagnetic housing shield 110 that is formed of an electrically conductive material, such as 70-30 brass or plated steel, is disposed within a cavity 112 in the housing 104. The housing shield 110 may be thin, e.g., having a thickness of about 0.3 millimeters. The connector shields 114 of the shielded electrical connectors 102 are in mechanical and electrical contact with the housing shield 110 as shown in FIG. 10.

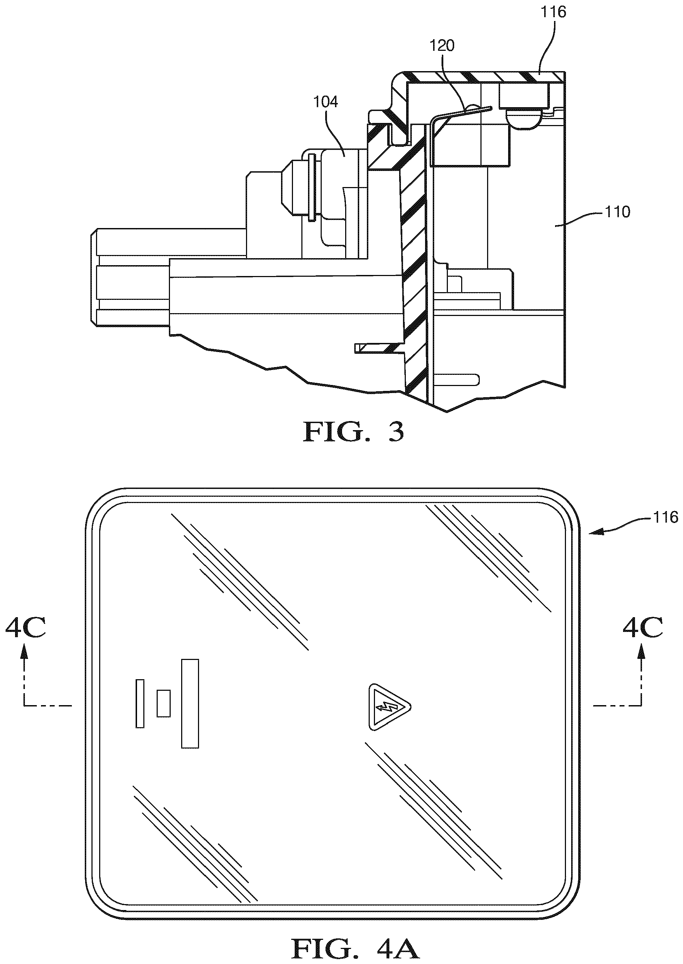

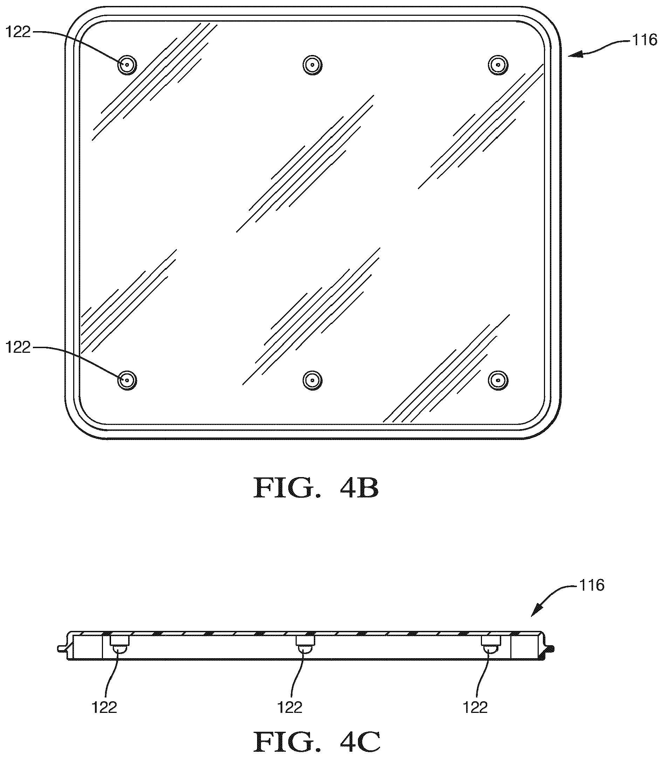

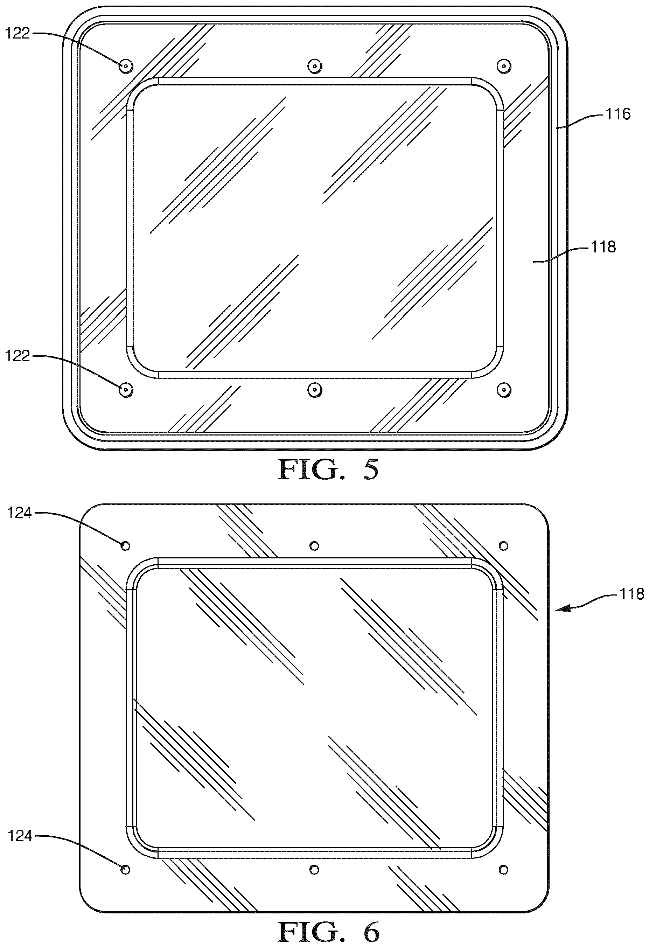

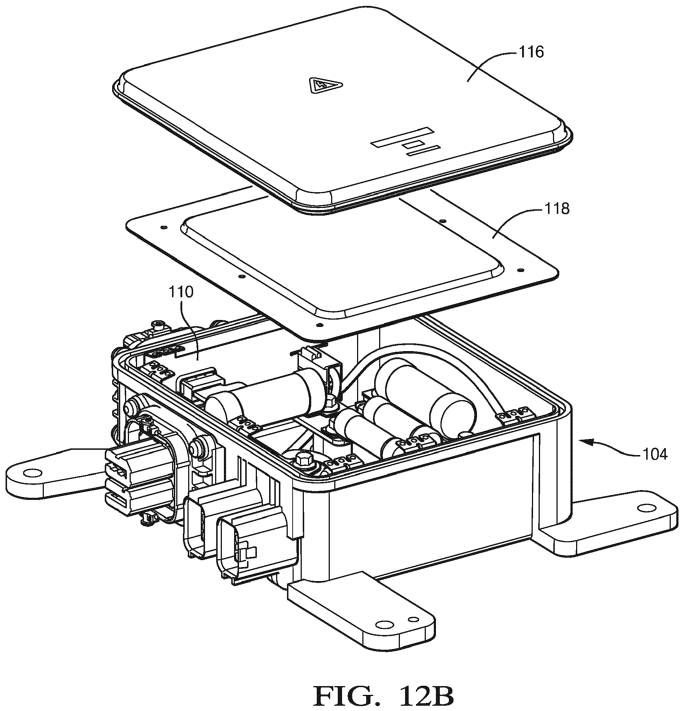

The electrical distribution center 100 also includes a cover 116, best shown in FIGs. 4A-4C that encloses the cavity 112. The cover 116 further includes an electromagnetic cover shield 118, best shown in FIGs. 5 and 6, that is formed of an electrically conductive material, preferable the same material, and is in mechanical and electrical contact with the housipreferably110. The housing shield 110 and the cover shield 118 are formed to fit inside of the cavity 112 of the housing 104 and the cover 116 of the electrical distribution center 100 as illustrated in FIGS 12A and 12B. As shown in FIGs. 3 and 5, the cover shield 118 is secured to the cover 116 using fasteners 122 such as snap fit features, rivets, screws, heat stake, etc. These fasteners 122 extend through apertures 124 defined in the cover shield 118. The housing shield 110 may also be secured within the housing 104 using similar fasteners.

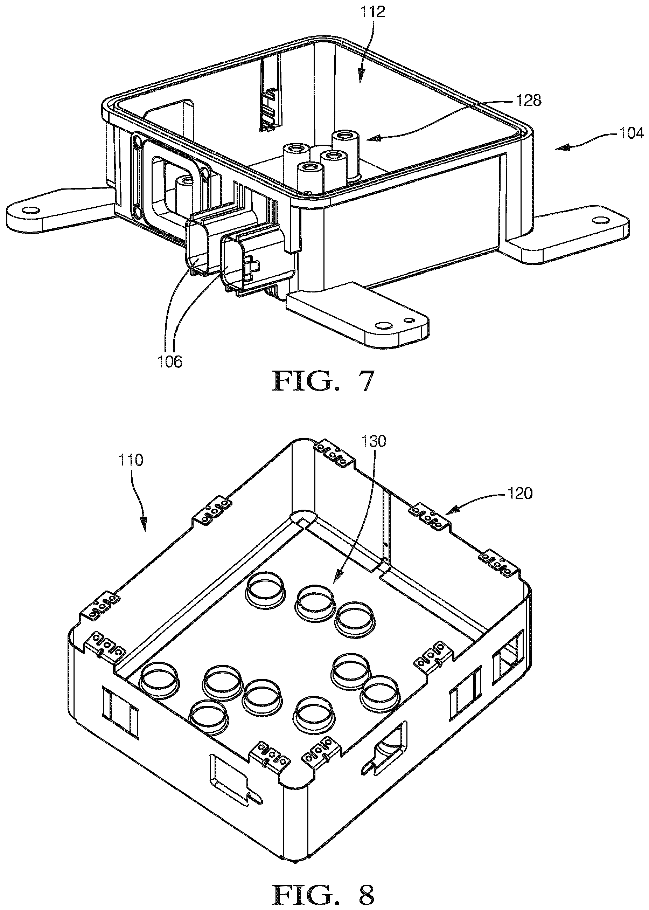

Inside the cavity 112 are a number of electrical components 126 interconnected to the shielded electrical connectors 102. The electrical components 126 may include wires, terminal, busbars, circuit protection devices, such as fuses as shown in Figs 2, and 14A-16D. The electrical components 126 may also include other component types such as high voltage contactors, solid state relays, electromechanical relays, diodes, etc. Some of these electrical components are mounted on standoffs 128, best shown in Fig 7, that are defined by an inner surface of the housing 104 and project into the cavity 112. These standoffs 128 extend through apertures 130, best seen in FIG. 9 that are defined in the housing shield 110.

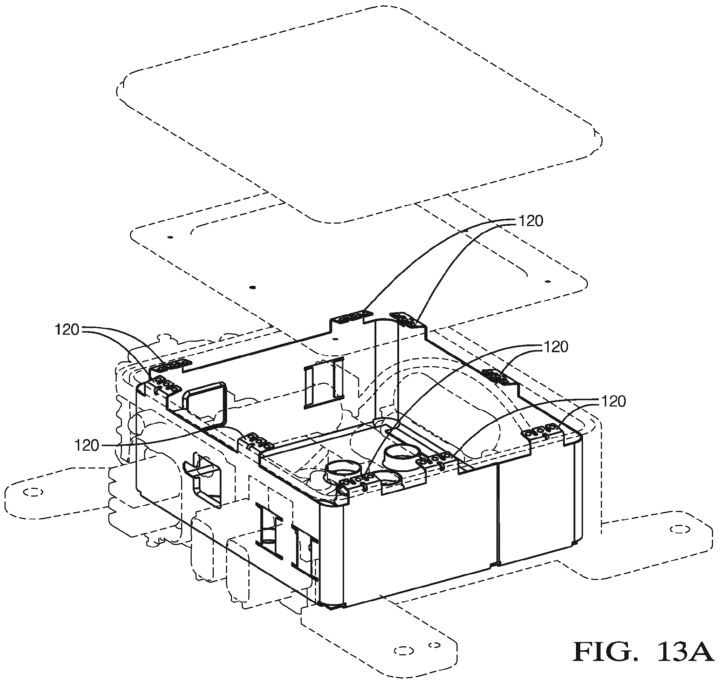

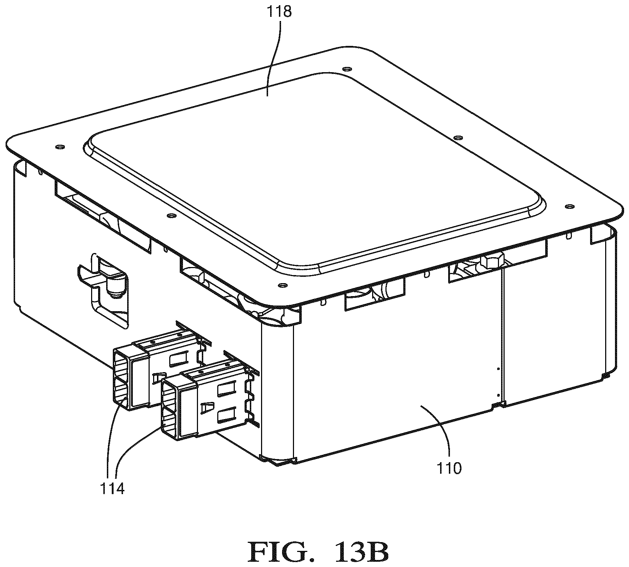

As best seen in FIGs. 3, 8, and 13A, there are spring tabs 120 around the edges of the housing shield 110 that electrically interconnect the housing shield 110 with the cover shield 118 by exerting a spring contact force as illustrated in FIG. 13B, thereby forming a Faraday cage around the electrical components 126 within in the housing shield 110 and the cover shield 118.

The cover 116 may be welded to the housing 104 using a laser welding process as shown in FIGs. 3. In other embodiments, the cover may be removable fastened to the housing, e.g., by threaded fasteners in order to service fuses or other electrical devices in the cavity.

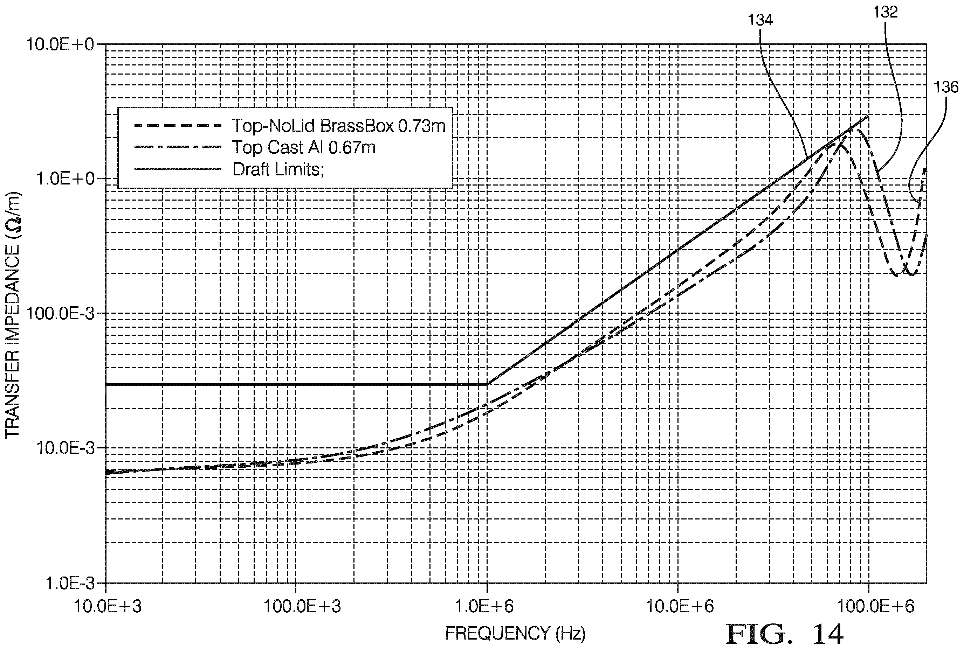

The housing shield 110 and the cover shield 118 cooperate to provide a direct current (DC) resistance between the connector shields is less than or equal to 2.5 milliohms. The housing shield 110 and the cover shield 118 further provide an AC transfer impedance that is less than or equal to 30 milliohms/meter in a frequency range of 10 kilohertz to 1 Megahertz and is less than or equal to 3 × 10⁻⁸ × *f* milliohms/meter in a frequency range 1 Megahertz to 100 Megahertz, where *f* is the frequency of electricity being conducted by the plurality of shielded electrical connectors 102. As shown in the graph of the test results of AC transfer impedance vs. frequency in FIG. 14, the AC transfer characteristics 132 of the electrical distribution center 100 meet the limits 134 specified above and are similar to the AC transfer characteristics 136 of an electrical distribution center having an aluminum housing (not shown). These AC transfer impedance characteristics are achieved even with the apertures in the housing and cover shields. The configuration of the connector, housing, and cover shields have no electrical discontinuities and radio frequency energy is distributed evenly throughout the housing shield 110, the connector shields 114, and the cover shield 118.

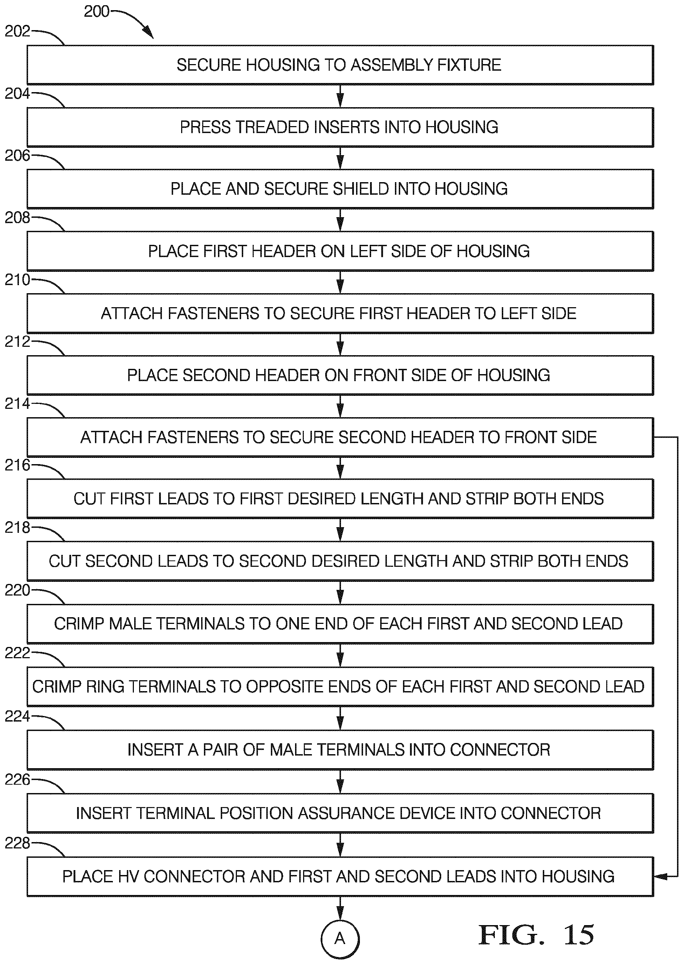

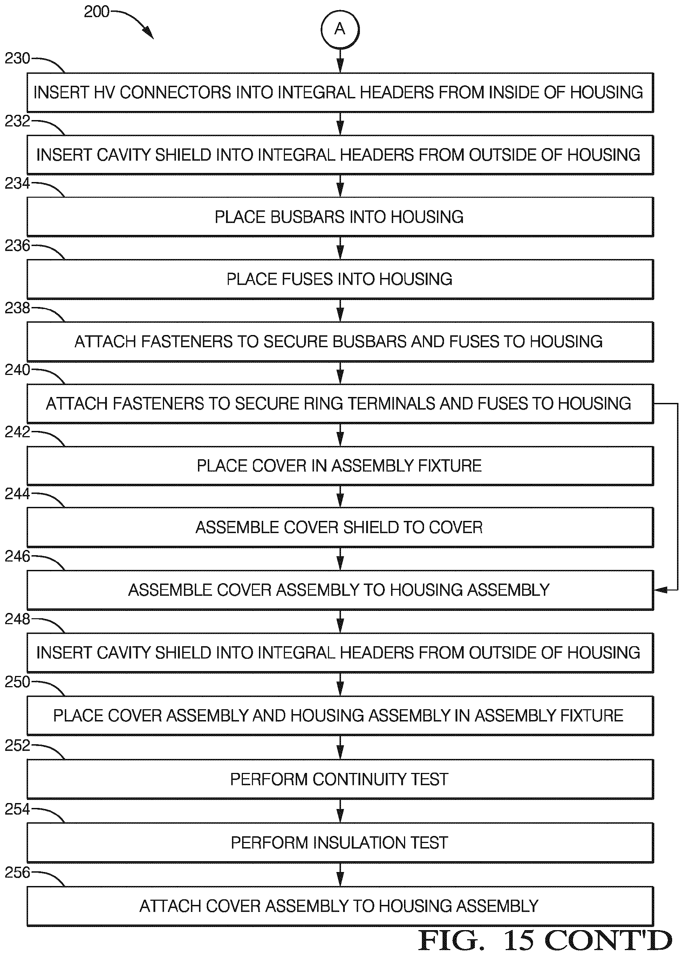

FIG. 15 shows a flow chart of a process 200 of assembling the housing 104/housing shield 110 subassembly, the cover 116/cover shield 118 subassembly, the shielded electrical connectors 102, and the electrical components 126, and fasteners 108 to form the electrical distribution center 100.
STEP 202, SECURE HOUSING TO ASSEMBLY FIXTURE, includes secure the housing to an assembly fixture (not shown);
STEP 204, PRESS TREADED INSERTS INTO HOUSING, includes pressing treaded inserts into the housing;
STEP 206, PLACE AND SECURE SHIELD INTO HOUSING, includes placing and securing the shield into the housing;
STEP 208, PLACE FIRST HEADER ON LEFT SIDE OF HOUSING, includes placing the first header on the left side of the housing 104;
STEP 210, ATTACH FASTENERS TO SECURE FIRST HEADER TO LEFT SIDE, includes attaching threaded fasteners to secure the first header to the left side of the housing 104;
STEP 212, PLACE SECOND HEADER ON FRONT SIDE OF HOUSING, includes placing the second header on the front side of the housing;
STEP 214, ATTACH FASTENERS TO SECURE SECOND HEADER TO FRONT SIDE, includes attaching threaded fasteners to secure the second header to the front side of the housing;
STEP 216, CUT FIRST LEADS TO FIRST DESIRED LENGTH AND STRIP BOTH ENDS, includes cutting first leads to first desired length and strip both ends of the first leads;
STEP 218, CUT SECOND LEADS TO SECOND DESIRED LENGTH AND STRIP BOTH ENDS, includes cutting second leads to second desired length and strip both ends of the second leads;
STEP 220, CRIMP MALE TERMINALS TO ONE END OF EACH FIRST AND SECOND LEAD, includes crimping male terminals to one end of each first and second lead;
STEP 222, CRIMP RING TERMINALS TO OPPOSITE ENDS OF EACH FIRST AND SECOND LEAD, includes crimping ring terminals to the ends of each first and second lead opposite the end on which the male terminals are crimped;
STEP 224, INSERT A PAIR OF MALE TERMINALS INTO CONNECTOR, includes inserting a pair of male terminals into the connector;
STEP 226, INSERT A TERMINAL POSITION ASSURANCE DEVICE INTO CONNECTOR, includes inserting a terminal position assurance device into the connector;
STEP 228, PLACE HV CONNECTOR AND FIRST AND SECOND LEADS INTO HOUSING, immediately follows both STEP 214 and STEP 228 and includes placing a high voltage connector connector and the first and second leads into the housing;
STEP 230, INSERT HV CONNECTORS INTO INTEGRAL HEADERS FROM INSIDE OF HOUSING, includes inserting high voltage connectors into the integral headers of the housing from the inside of the housing 104;
STEP 232, INSERT CAVITY SHIELD INTO INTEGRAL HEADERS FROM OUTSIDE OF HOUSING, includes inserting the cavity shield into the integral headers of the housing from the outside of the housing;
STEP 234, PLACE BUSBARS INTO HOUSING, includes placing the busbars into the housing;
STEP 236, PLACE FUSES INTO HOUSING, includes placing the fuses into the housing;
STEP 238, ATTACH FASTENERS TO SECURE BUSBARS AND FUSES TO HOUSING, includes attaching fasteners to secure the busbars and fuses to the housing;
STEP 240, ATTACH FASTENERS TO SECURE RING TERMINALS AND FUSES TO HOUSING, includes attaching fasteners to secure the ring terminals and fuses to the housing;
STEP 242, PLACE COVER IN ASSEMBLY FIXTURE, includes placing the cover in the assembly fixture;
STEP 244, ASSEMBLE COVER SHIELD TO COVER, includes assembling the cover shield to the cover;
STEP 246, ASSEMBLE COVER ASSEMBLY TO HOUSING ASSEMBLY, follows both steps 240 and 244 and includes assembling the cover assembly to the housing assembly;
STEP 248, INSERT CAVITY SHIELD INTO INTEGRAL HEADERS FROM OUTSIDE OF HOUSING, includes inserting the cavity shield into the integral headers of the housing from the outside of the housing;
STEP 250, PLACE COVER ASSEMBLY AND HOUSING ASSEMBLY IN ASSEMBLY FIXTURE, includes placing the cover assembly and the housing assembly into another assembly fixture (not shown);
STEP 252, PERFORM CONTINUITY TEST, includes performing a continuity test;
STEP 254, PERFORM INSULATION TEST, includes performing an insulation test; and
STEP 256, ATTACH COVER ASSEMBLY TO HOUSING ASSEMBLY, includes attaching the cover assembly to the housing assembly, e.g., by laser welding, adhesives, or threaded fasteners.

Traditionally, original equipment manufacturers (OEMs) of vehicles have avoided high voltage electrical distribution centers made of plastic materials due to several technical concerns, including damage caused to the high voltage distribution centers in a crash that could put high volage conductors (busbars) in high voltage electrical distribution centers into contact with metallic components of the vehicle.

However, engineered plastics, such as glass filled polybutylene terephthalate (PBT) have been shown to be as durable as aluminum even in crash situations. Housings formed of these engineered plastics are more flexible and can accommodate the stresses generated by crash forces better than an aluminum housing.

In addition, aluminum is an electrically conductive material, which requires additional parts within the aluminum housing that are formed of plastic, or some other electrically non-conductive material, to provide electrical insulation between the electrically conducive busbars in the high voltage distribution center and the aluminum housing in order to avoid short circuits between the bus bars caused by contact with the aluminum housing. These additional insulators lead to higher piece price and assembly costs and also require a larger packaging volume for the distribution center.

Further, the plastic housing allows connector headers to be integrally molded into the housing rather than requiring separate headers that have to be attached to the aluminum housing. The plastic housing of the high voltage distribution center delivers a reduction in volume of the high voltage distribution center of about 25% mostly provided by the change from aluminum to plastic material. The plastic housing of the high voltage distribution center also affords a weight reduction of about 20-30%.

While the invention has been described with reference to an exemplary embodiment(s), it will be understood by those skilled in the art that various changes may be made, and equivalents may be substituted for elements thereof without departing from the scope of the invention. In addition, many modifications may be made to adapt a particular situation or material to the teachings of the invention without departing from the essential scope thereof. Therefore, it is intended that the invention is not limited to the disclosed embodiment(s), but that the invention will include all embodiments falling within the scope of the appended claims.

As used herein, 'one or more' includes a function being performed by one element, a function being performed by more than one element, e.g., in a distributed fashion, several functions being performed by one element, several functions being performed by several elements, or any combination of the above.

It will also be understood that, although the terms first, second, etc. are, in some instances, used herein to describe various elements, these elements should not be limited by these terms. These terms are only used to distinguish one element from another. For example, a first contact could be termed a second contact, and, similarly, a second contact could be termed a first contact, without departing from the scope of the various described embodiments. The first contact and the second contact are both contacts, but they are not the same contact.

The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

As used herein, the term "if' is, optionally, construed to mean "when" or "upon" or "in response to determining" or "in response to detecting," depending on the context. Similarly, the phrase "if it is determined" or "if [a stated condition or event] is detected" is, optionally, construed to mean "upon determining" or "in response to determining" or "upon detecting [the stated condition or event]" or "in response to detecting [the stated condition or event]," depending on the context.

Additionally, while terms of ordinance or orientation may be used herein these elements should not be limited by these terms. All terms of ordinance or orientation, unless stated otherwise, are used for purposes distinguishing one element from another, and do not denote any particular order, order of operations, direction or orientation unless stated otherwise.

## Claims

1. An electrical distribution center (100), comprising:
a housing (104) formed of an electrically nonconductive material;
an electromagnetic housing shield (110) formed of an electrically conductive material disposed within a cavity (112) in the housing (104);
a cover (116) enclosing the cavity (112) having an electromagnetic cover shield (118) formed of the electrically conductive material and in electrical contact with the housing shield (110); and
a plurality of shielded electrical connectors (102) interconnected to one another through electrical components (126) contained within the cavity (112), wherein electrical components (126) are mounted on a plurality of standoffs (128) defined by an inner surface of the housing (104), wherein the plurality of standoffs (128) extend through a plurality of apertures (130) defined in the housing shield (110).

2. The electrical distribution center (100) in accordance with claim 1, wherein the cover shield (118) is mounted to the cover (116) by a plurality of fasteners (122) and the plurality of fasteners (122) extend through a plurality of apertures (124) defined in the cover shield (118).

3. The electrical distribution center (100) in accordance with claim 1 or 2, wherein connector shields (114) of the plurality of shielded electrical connectors (102) are in electrical contact with the housing shield (110).

4. The electrical distribution center (100) in accordance with claim 3, wherein at least one of the connector shields (114) is disposed within a connector shroud (106) integrally formed by the housing (104).

5. The electrical distribution center (100) in accordance with any one of the preceding claims, wherein at least one of the electrical components (126) is a fuse.

6. The electrical distribution center (100) in accordance with any one of the preceding claims, wherein the housing shield (110) and the cover shield (118) are formed of brass alloy containing about 70% copper and about 30% tin.

7. The electrical distribution center (100) in accordance with claim 6, wherein the housing shield (110) and the cover shield (118) have a thickness of about 0.3 millimeters.

8. The electrical distribution center (100) in accordance with any one of the preceding claims, wherein the housing shield (110) and the cover shield (118) are formed of a sheet of steel material plated with a tin alloy or a copper alloy.

9. The electrical distribution center (100) in accordance with any one of the preceding claims, wherein the housing shield (110) comprises a plurality of spring tabs (120) configured to make electrical contact with the cover shield (118).

10. The electrical distribution center (110) in accordance with any one of the preceding claims, wherein the cover (116) is welded to the housing (104).

11. An electrical distribution center (100), comprising:
a housing (104) formed of an electrically nonconductive material;
an electromagnetic shield (110) formed of an electrically conductive material disposed within a cavity (112) in the housing (104); and
a plurality of shielded electrical connectors (102) interconnected to one another within the cavity (112), wherein connector shields (114) of the plurality of shielded electrical connectors (102) are in electrical contact with the housing shield (10), wherein a DC resistance between the connector shields (114) is less than or equal to 2.5 milliohms, and wherein an AC transfer impedance is less than or equal to 30 milliohms/meter in a frequency range of 10 kilohertz to 1 Megahertz and is less than or equal to 3 × 10⁻⁸ × *f* milliohms/meter in a frequency range 1 Megahertz to 100 Megahertz, where *f* is the frequency of electricity being conducted by the plurality of shielded electrical connectors (102).

12. The electrical distribution center (100 in accordance with claim 11, wherein at least one of the connector shields (114) is disposed within a connector shroud (106) integrally formed by the housing (104).

13. The electrical distribution center (110) in accordance with claim 11 or 12, wherein there is no electrical discontinuity between the electromagnetic shield (110) and the connector shields (114).

14. The electrical distribution center (110) in accordance with any one of claims 11 to 13, further comprising:
electrical components (126) contained within the cavity (112) and mounted on a plurality of standoffs (128) defined by an inner surface of the housing (104), wherein the plurality of standoffs (128) extend through a plurality of apertures (130) defined in the electromagnetic shield (110).

15. The electrical distribution center in accordance with any one of claims 11 to 13, wherein the electromagnetic shield (110) is mounted on a plurality of standoffs (128) extending from an inside surface of the housing (104) and wherein tips of the plurality of standoffs (128) extend through a plurality of apertures (130) defined in the electromagnetic shield (110).
